(19) Europäisches Patentamt

European Patent Office

Office européen des brevets

(11) Publication number: **0 182 665 B1**

## (12) EUROPEAN PATENT SPECIFICATION

(45) Date of publication of patent specification: **18.09.91**  (51) Int. Cl.⁵: **H01J 37/317, G03F 7/20**

(21) Application number: **85308461.4**

(22) Date of filing: **20.11.85**

### (54) Method of projecting a photoelectron image.

(30) Priority: **20.11.84 JP 243343/84**
**20.11.84 JP 243342/84**
**29.11.84 JP 252151/84**

(43) Date of publication of application:
**28.05.86 Bulletin 86/22**

(45) Publication of the grant of the patent:
**18.09.91 Bulletin 91/38**

(84) Designated Contracting States:
**DE FR GB**

(56) References cited:
**EP-A- 0 127 919**
**FR-A- 2 515 873**
**GB-A- 2 111 299**

**PATENTS ABSTRACTS OF JAPAN, vol. 4, no. 44 (E-5)[526], page 81 E 5; & JP-A-55 15 232 (RIKAGAKU KENKYUSHO) 02-02-1980**

(73) Proprietor: **FUJITSU LIMITED**
**1015, Kamikodanaka Nakahara-ku**
**Kawasaki-shi Kanagawa 211(JP)**

(72) Inventor: **Yasuda, Hiroshi**
**1505-1, Futoo-cho Kohoku-ku**
**Yokohama-shi Kanagawa 222(JP)**
Inventor: **Honjo, Ichiro**
**2552-2-A201, Oaza Kamigo Toyosatomachi**
**Tsukuba-gun Ibaragi 300-26(JP)**

(74) Representative: **Fane, Christopher Robin King et al**
**HASELTINE LAKE & CO. Hazlitt House 28**
**Southampton Buildings Chancery Lane**
**London, WC2A 1AT(GB)**

## Description

The present invention relates to a method of projecting a photoelectron image.

Photolithography is an important technique in the production of, for example, VLSI integrated circuits. Among the photolithography techniques, there are techniques of projecting a fine pattern on wafers or the like. One of these is the "Direct-Stepping-on Wafer" (DSW) process, wherein a scaled down, e.g. 5:1 or 10:1, projection exposure process using light (having a wavelength of about 0.4 $\mu$m (4000Å)) is carried out using a reticle as an original print. However, the DSW process has a resolution limit of about 1 $\mu$m.

In order to improve the resolution, an electron beam exposure process or X-ray exposure process can be used.

In the electron beam exposure process, the electron beam is focussed to a point or a rectangular shape and scanned across a wafer to be exposed, so that the exposure time increased in comparison with the projection exposure process. The electron beam exposure process therefore has a small throughput.

The X-ray exposure process uses a large-scale X-ray source, of, for example, 10 to 50 kW, and having a wavelength of 0.1 nm to 1 nm, whereby proximity exposure is carried out. Thus, the X-ray exposure process requires a highly accurate aligner to support and align the mask and wafer. In this respect, the X-ray exposure is similar to conventional optical exposure.

However, there are problems in that the X-ray exposure process is very costly owing to the large scale of the radiation source and the necessary properties of mask materials having regard to the desired absorption coefficient and the wavelength of the radiation. One such radiation source used for generating X-rays is a synchrotron emission source which is undesirably large in scale and high in cost. Furthermore, in X-ray processes blurring can occur owing to changes in the gap between the mask and wafer caused by warping of the wafer.

Recently, ion beam exposure processes have been studied. However, ion beam exposure has the same problems as electron beam exposure.

In a known electron beam projecting process, a mask structure is produced by forming a pattern, complementary to the desired image, of an ultraviolet-radiation-absorbing material, such as Cr, on a main face of a crystal glass substrate and overlying that pattern and the rest of the said main face with a layer of photoelectric material, such as CsI, of the kind from which electrons are emitted upon irradiation with ultraviolet light. When ultraviolet light is passed through the crystal glass substrate to irradiate the photoelectric layer (back illumination), photoelectrons are emitted only from the portions of the photoelectric layer that contact the crystal glass, and not from the portions of the photoelectric material on the ultraviolet absorber. The emitted electrons are focussed to form the required image on an electron sensitive resist, provided on a wafer, by means of a magnetic field that is applied between the photoelectric layer and the wafer.

However, the electron sensitive resist on the wafer exhibits some sensitivity also to residual ultraviolet light that passes through the mask, particularly when such light has a large energy. This can prevent accurate projection of the pattern of the mask, resulting in blurring of the image.

In a known method of projecting electrons to form an image of a predetermined pattern, the said pattern is defined on a main face of a substrate by covering areas of the said main face that do not form part of the said pattern with masking material, by forming an overlying layer which covers the said masking material and the pattern-forming areas of the said main face, which areas are not covered by the said masking material, and by directing radiation onto the resulting structure in a vacuum, in the presence of electric and magnetic focusing fields, so as to bring about emission, in the direction from the substrate to the said overlying layer, of photoelectrons for the forming the said image. According to the present invention the said radiation is directed to be incident on the said layer without first passing through the said substrate; the said layer having a work-function-lowering effect on the pattern-forming areas, which are contacted by that layer, such that the said photoelectrons are emitted from those areas.

Reference will now be made, by way of example, to the accompanying drawings, in which:-

Fig. 1 is a schematic view of apparatus for putting into effect a conventional method of projecting a photoelectron image;

Fig. 2 is a schematic view illustrating a step in a method embodying the present invention;

Fig. 3 is a schematic view of apparatus for putting into effect a method embodying the present invention;

Fig. 4 is a side-elevational view of a part of the apparatus of Fig. 3;

Fig. 5 is a diagram illustrating the variation of potential in the part of Fig. 4;

Fig. 6 is a diagram illustrating a modification to the part of Fig. 4;

Fig. 7 is a side-elevational view of a mask structure for use in a method embodying the present invention;

Fig. 8 is a graph showing the relationship between irradiated light energy and quantum efficiency for the mask structure of Fig. 7;

Fig. 9 is an energy band diagram of GaAs-Cs;

Fig. 10 is a diagram illustrating a wafer alignment operation carried out in the apparatus of Fig. 3;

Figs. 11 and 12 show respective schematic views of arrangements for use in carrying out the alignment operation of Fig. 10; and

Fig. 13 shows a schematic view of a modified form of the part of Fig. 4.

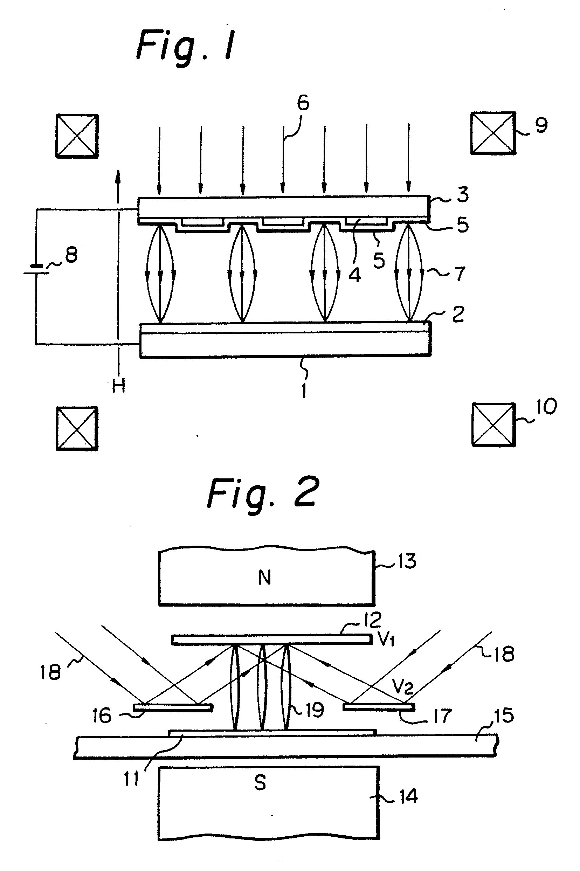

As shown in Fig. 1, a semiconductor wafer 1 has formed thereon an electron-sensitive resist layer 2. Masking material 4, such as Cr, is deposited on selected areas of a main face of a transparent mask substrate 3, such as quartz. On the surface of the obtained mask, a layer 5 from which photoelectrons are to be emitted, for example a Pd layer (having a thickness of about 4nm (40Å)) or CsI layer (having a thickness of about 50nm (500Å)) is formed. Between the obtained mask and the semiconductor wafer, a uniform magnetic field H is applied and a biassing voltage is applied by an electric source 8, so that the mask is maintained at a negative potential with respect to the wafer. Reference numerals 9 and 10 denote respective Helmholtz coils.

In Fig. 1, the mask substrate 3 is irradiated with ultraviolet light 6 so as to provide back illumination of the layer 5 from which the photoelectrons are to be emitted (hereinafter referred to as the photoelectron layer). The portions of the Cr masking material underlying the photoelectron layer 5 absorb the ultraviolet light, preventing it from reaching the layer 5. On the other hand, where no underlying Cr portions are present, the ultraviolet light reaches the photoelectron layer 5 and photoelectrons 7 are emitted therefrom having a kinetic energy obtained by subtracting the work function $\phi$ of the photoelectron emitting substance from the light energy $h\nu$. The emitted photoelectrons are focussed on the surface of the wafer 1 by the magnetic field H and the electric field provided by the electric source 8.

In the back illumination process using ultraviolet light some ultraviolet light may pass through the Cr masking material 4 and reach the wafer 1, so that, since the electron-sensitive resist 2 reacts to the ultraviolet light, a desirably accurate projecting process may not be achieved.

CsI, if used as the photoelectron layer 5, needs to be irradiated with light having a short-wavelength (184.9nm (1049Å), corresponding to 6.7 eV; ultraviolet region in vacuum). Suitable short-wavelength light sources and lens systems are not widely available.

As shown in Fig. 2, a uniform electric field is applied between an N pole 13 and an S pole 14 of a magnet. A wafer 11 and a mask structure 12 are disposed opposite one another between the poles. The wafer 11 is provided on a stage 15. Between the wafer 11 and mask structure 12, reflectors 16 and 17 are disposed. Ultraviolet or visible light 18 is reflected by the reflectors to be incident on a photoelectron layer provided on one main face of the mask 12 without first passing through the mask substrate. Photoelectrons 19 emitted from the photoelectron layer surface are focussed at the surface of the wafer 11. In the method illustrated schematically in Fig. 2, the wafer can be exposed by the step-and-repeat system, using an exposed area of, for example, 10 to 300 mm² in each exposure operation.

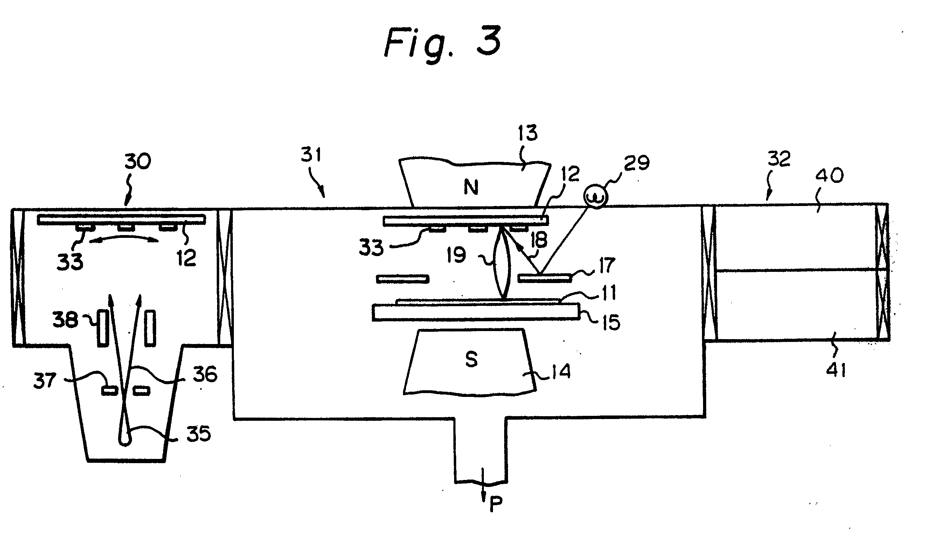

Figure 3 is a schematic view of apparatus for putting into effect an embodiment of the present invention.

A Pt layer 33 (having a thickness of 50nm (500Å)) is formed on a GaAs mask substrate 12 by a vacuum evaporation process, then the Pt layer 33 is patterned. The resulting mask structure is then introduced into a vacuum chamber 30 of the apparatus of Fig. 3 which acts as a subchamber.

The exposed Pt layer 33 and GaAs substrate 12 are irradiated with an alkali metal beam, e.g. a Cs ion beam 36 generated from a Cs source 35 in a well-known ion beam generator, so that an overlying photoelectron-active layer of Cs is formed thereon. In Fig. 3, reference numerals 37 and 38 denote a leading electrode and an electrostatic polarization electrode, respectively.

The resulting mask structure is moved to a second vacuum chamber 31 which acts as a main chamber. A wafer 11 is disposed therein so that it faces the Cs layer of the mask structure.

Light 18 is generated by a light source 29, e.g. a halogen lamp, and reflected by a mirror 17 so that the surface of the mask structure is irradiated with the light 18, whereby the image formed by photoelectrons 19 emerging from the Cs layer is projected onto the wafer 11. In this case a bias of about -80kV is applied on the mask substrate side to emit the photoelectrons 19.

Further, in order to accurately focus the emitted photoelectrons on to the wafer surface, a uniform magnetic field is applied so that the mask structure is adjacent to the N pole 13 and the wafer is adjacent to the S pole 14. Connecting with the second vacuum chamber 31, a third vacuum chamber 32 is provided. The third vacuum chamber 32 comprises respective separate sub-chambers 40 and 41 for holding the mask substrate and the wafer, respectively.

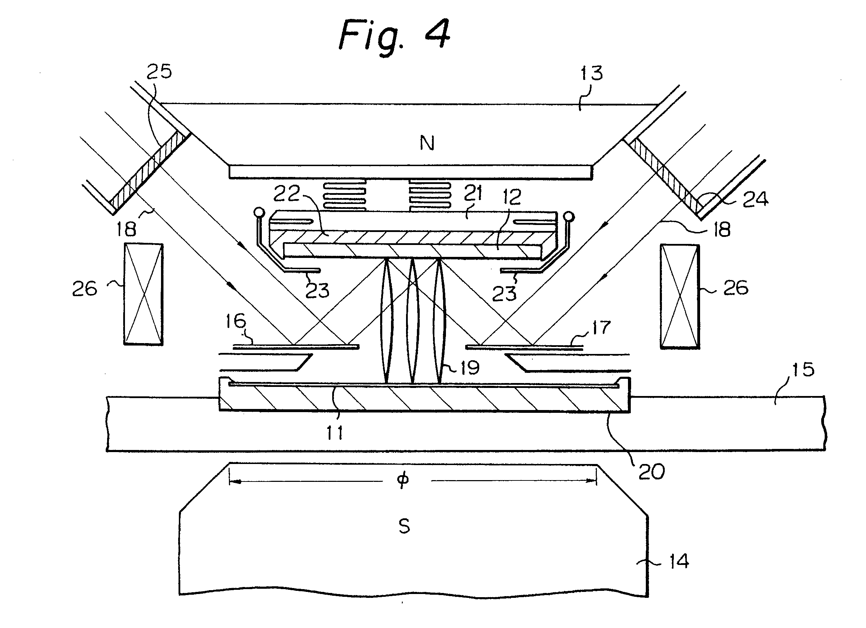

Figure 4 is a view showing the second vacuum chamber of Fig. 3 in more detail.

In Fig. 4 the mask 12 and wafer 11 are disposed between the N pole 13 and S pole 14 of the magnet so that the mask 12 faces the wafer 11. The wafer 11 is fixed by a wafer holder 20 with a chuck and the wafer holder 20 is rotatable on a stage 15 which can be moved in a horizontal plane in X- and Y-directions. Visible light 18, passed through windows 24 and 25, is reflected by reflectors 16 and 17, whereby the photoelectron layer surface of the mask 12 is irradiated with the light 18. The emitted electrons 19 are focussed on to the surface of the wafer 11. The mask 12 is held by a mask holder 22, which is supported by an electrically insulating ceramic material 21. A magnetic field for focusing the electrons is provided by the poles 13 and 14 (having a cross section $\phi$ of about 40 mm). Between the respective end faces of the poles 13 and 14, a uniform magnetic field can be formed.

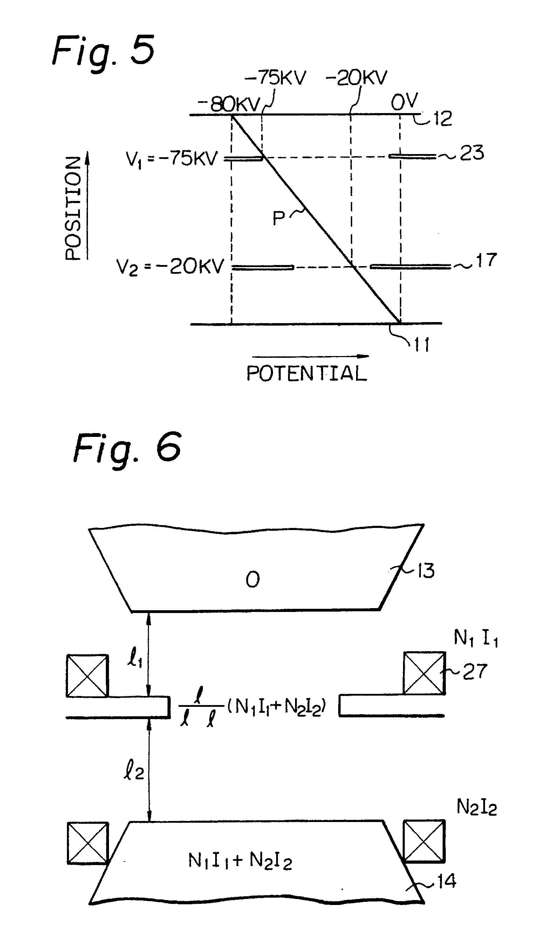

In addition, a uniform electrical field is required. To this end, a bias of, for example, -80 kV is applied to the mask, the potential of the wafer 11 being 0V. In this case, as shown in Fig. 5, if appropriate voltages are applied to an electrode plate 23 and a reflector 17 so that the potential P in the space between the wafer and the mask changes linearly, the electric field will be substantially uniform across the space.

In order to obtain a more uniform magnetic field, a compensator may be used, as shown in Fig. 6.

In Fig. 6, when the magnetic potential of the N pole 13 is 0 and the magnetic potential of the S pole 14 is $N_1 I_1 + N_2 I_2$, if a compensating coil 27 is positioned such that the expression

$$\frac{\ell_1}{\ell_1 + \ell_2} (N_1 I_1 + N_2 I_2) = N_1 I_1$$

is satisfied, the magnetic potential of the surface near the compensating coil 27 can be fixed so that a substantially linear magnetic field is produced between the poles. In the above expression, $\ell_1$ and $\ell_2$ are the distances between the compensating coil and the magnetic poles 13 and 14, respectively. $N_1 I_1$ and $N_2 I_2$ have the unit of ampere turns.

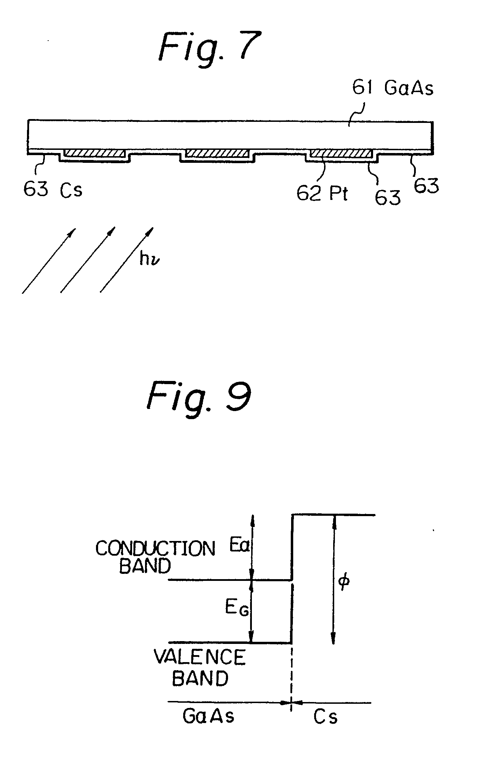

Figure 7 shows a schematic view of a mask for use in a method embodying the present invention. As shown in Fig. 7, a GaAs mask substrate 61 has, on a main face thereof, a pattern defined by covering areas of the main face that do not form part of the pattern with masking material 62 such as Pt. Further, on the patterned surface, an overlying photoelectron layer 63 of alkali metal such as Cs is formed. Electrons are emitted when light having an energy greater than about 1.5 eV is incident upon the Cs layer. The quantum efficiency becomes well enhanced at energies of 2 to 3 eV. The overlying layer 63 may alternatively be formed by oxidizing Cs several times to form several Cs-O layers.

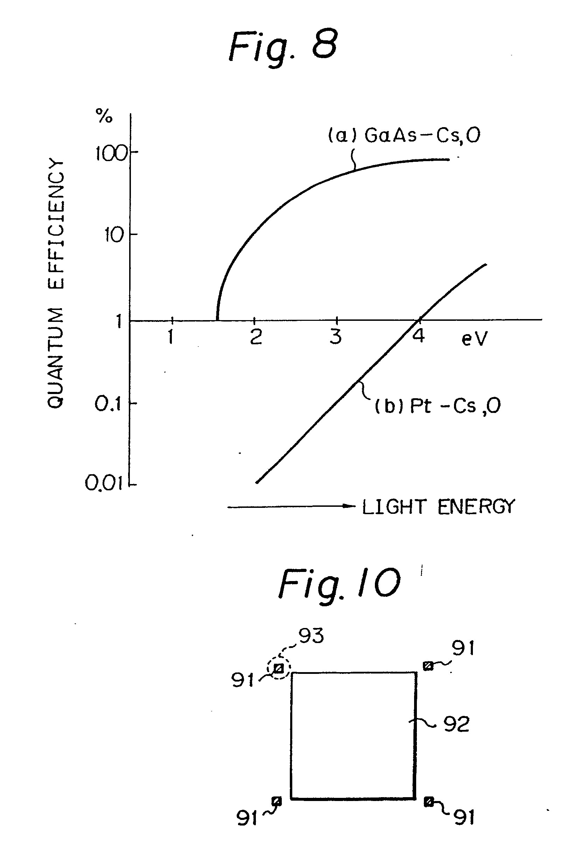

In Figure 8 graphs (a) and (b) show the relationships between quantum efficiency and irradiating light energy in the cases where GaAs and Pt respectively underlie the layer 63. As shown in Fig. 8, the quantum efficiency for a given incident light energy is higher in case (a) than in case (b).

Figure 9 is an energy diagram of GaAs-Cs. In Fig. 9, $E_G$ and $E_a$ are the band gap and electron affinity of GaAs respectively, and $\phi$ is the work function. The larger $E_G/E_a$ becomes, the more the quantum efficiency is enhanced. In the case of GaAs-Cs, $E_G/E_a \geq 1$ and, thus, the quantum efficiency is high. The Cs layer has a work-function-lowering effect on the areas of GaAs contacted by that layer, thereby facilitating emission of photoelectrons from those pattern-forming areas of the GaAs substrate.

In the back illumination process of Fig. 1, a transparent mask is provided on a front face thereof with masking material which absorbs light. Then, a photoelectron layer is formed on the entire front face.

On the other hand, in an embodiment of the present invention a mask substrate has formed on it two kind of areas having different quantum efficiencies, whereby the respective quantities of photoelectrons emitted from the areas are different. As discussed with reference to Fig. 7, a suitable overlying layer may be formed by Cs deposition or a Cs treatment process to cover both the above-mentioned areas. In embodiments of the present invention, almost all photoelectron materials can be used to form the overlying layer but Cs or Cs-treated Sb or Cs-treated Te or Cs-treated $Ag_2O$, etc., are preferable. For example, a Cs-treated Sb layer is produced by forming an Sb layer on, for example, a sapphire substrate and forming a Cs layer on the Sb layer. In turn, areas from which photoelectrons are not to be emitted are made of metal, for example Pt, Cr, W, Mo, Ta, Au, Ag and Ti.

In order to align a mask with a wafer, as shown in Fig. 10, a mark 91 for alignment is provided around a mask pattern 92. At least two marks 91 are needed to detect rotation. When the mask is aligned with the wafer, light is shut off with shutters (in Fig. 4, windows 24 and 25 are closed), and another strong light 93 illuminates only the portions of the marks 91. Then, using electrons emitted from the marks 91, the marks 91 are superposed on marks of the wafer to align the mask with the wafer.

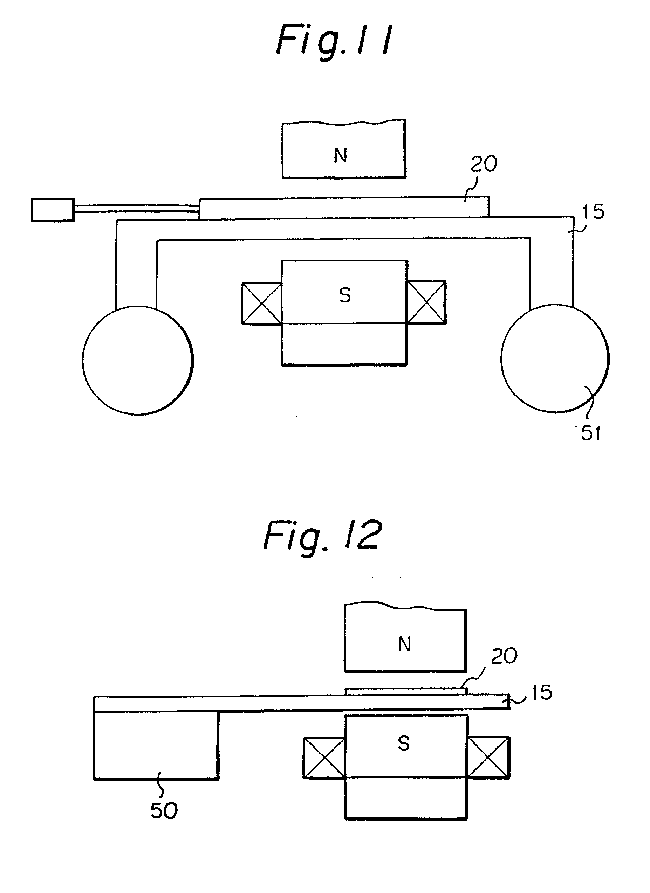

Figures 11 and 12 show respective stages for use in the apparatus of Fig. 3. As shown in Fig. 11, a stage 15 carrying the wafer can be moved in the X- and Y- directions. A wafer holder 20 with a chuck (not shown) is movable rotatably.

51 denotes an air bearing component.

In a further stage shown in Fig. 12, a mechanism 50 for moving the stage is provided to one side thereof. Instead of the use of a stage, a mark detection scanner (MD) may be used for alignment.

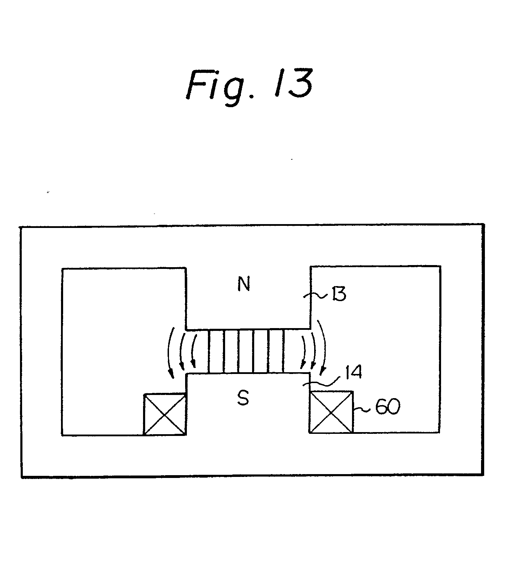

A magnetic arrangement for use in the apparatus of Fig. 3 is shown in Fig. 13, in which, in place of the N and S poles 13 and 14, use is made of an electromagnet composed of a coil through which current is passed.

## Claims

1. A method of projecting electrons to form an image of a predetermined pattern, wherein the said pattern is defined on a main face of a substrate (61) by covering areas of the said main face that do not form part of the said pattern with masking material (62), forming an overlying layer (63) which covers the said masking material (62) and the pattern-forming areas of the said main face, which areas are not covered by the said masking material, and directing radiation onto the resulting structure in a vacuum, in the presence of electric and magnetic focussing fields, so as to bring about emission, in the direction from the substrate (61) to the said overlying layer (63), of photoelectrons for forming the said image;

   characterised in that the said radiation is directed to be incident on the said layer (63) without first passing through the said substrate (61); the said layer (63) having a work-function-lowering effect on the pattern-forming areas, which are contacted by that layer, such that the said photoelectrons are emitted from those areas.

2. A method as claimed in Claim 1, wherein the said substrate (61) is made of GaAs, GaP, quartz, or sapphire.

3. A method as claimed in Claim 1 or 2, wherein the said masking material (62) is Pt, Cr, W, Mo, Ta, Au, Ag, or Ti.

4. A method as claimed in any preceding claim, wherein the said overlying layer (63) is made of an alkali metal or an alkaline earth metal.

5. A method as claimed in Claim 4, wherein the said overlying layer (63) is made of Cs.

6. A method as claimed in Claim 4, wherein the said overlying layer (63) is made of Ba.

7. A method as claimed in claim 4, 5 or 6, wherein the said overlying layer (63) is formed by means of ion beam irradiation in a vacuum.

8. A method as claimed in Claim 1, 2 or 3, wherein the said overlying layer (63) is made of Cs-treated Sb, Cs-treated Te, or Cs-treated $Ag_2O$.

## Revendications

1. Procédé de projection d'électrons permettant de former une image d'un motif prédéterminé, où on définit ledit motif sur une face principale d'un substrat (61) en recouvrant, à l'aide d'un matériau de masquage (62), des aires de ladite face principale qui ne font pas partie dudit motif, en formant une couche sus-jacente (63) qui couvre ledit matériau de masquage (62) et les aires de formation de motif de ladite face principale, lesquelles aires ne sont pas recouvertes par ledit matériau de masquage, et en dirigeant, dans le vide, un rayonnement sur la structure résultante, en présence de champs de focalisation électriques et magnétiques, afin de provoquer l'émission, dans une direction allant du substrat (61) à ladite couche sus-jacente (63), de photoélectrons servant à former ladite image ;

   caractérisé en ce que ledit rayonnement est dirigé de façon à arriver sur ladite couche (63) sans être d'abord passé au travers dudit substrat (61) ; ladite couche (63) ayant un effet d'abaissement du travail d'extraction sur les aires de formation de motif, qui sont en contact avec cette couche, si bien que lesdits photoélectrons sont émis depuis ces aires.

2. Procédé selon la revendication 1, où ledit substrat (61) est fait de GaAS, de GaP, de quartz ou de saphir.

3. Procédé selon la revendication 1 ou 2, où ledit matériau de masquage (62) est Pt, Cr, W, Mo, Ta, Au, Ag ou Ti.

4. Procédé selon l'une quelconque des revendications précédentes, où ladite couche sus-jacente (63) est faite d'un métal alcalin ou d'un métal alcalino-terreux.

5. Procédé selon la revendication 4, où ladite couche sus-jacente (63) est faite de Cs.

6. Procédé selon la revendication 4, où ladite couche sus-jacente (63) est faite de Ba.

7. Procédé selon la revendication 4, 5 ou 6, où on forme ladite couche sus-jacente (63) par irradiation à l'aide d'un faisceau d'ions dans le vide.

8. Procédé selon la revendication 1, 2 ou 3, où ladite couche sus-jacente (63) est faite de Sb traité par Cs, Te traité par Cs, ou $Ag_2O$ traité par Cs.

**Patentansprüche**

1. Verfahren zum Projizieren von Elektronen, um ein Bild von einem vorbestimmten Muster zu bilden, bei dem das genannte Muster auf einer Hauptoberfläche eines Substrates (61) begrenzt wird durch Bedecken von Bereichen der genannten Hauptoberfläche, die nicht Teil des genannten Musters bilden, mit einem Maskenmaterial (62), Bilden einer darüberliegende Schicht (63), die das genannte Maskenmaterial (62) und die musterbildenden Bereiche der genannten Hauptoberfläche bedeckt, welche Bereiche nicht von dem genannten Maskenmaterial bedeckt sind, und Richten von Strahlung auf die resultierende Struktur in einem Vakuum, in Gegenwart von elektrischen und magnetischen Fokussierungsfeldern, um so, in Richtung von dem Substrat (61) zu der genannten darüberliegenden Schicht (63), eine Emission von Photoelektronen herbeizuführen, um das genannte Bild zu bilden;
   dadurch gekennzeichnet, daß die genannte Strahlung so gerichtet ist, daß sie auf die genannte Schicht (63) auftrifft, ohne erst durch das genannte Substrat (61) hindurchzutreten; die genannte Schicht (63) einen Austrittsarbeits-Verringerungseffekt auf die musterbildenden Bereiche hat, welche durch die genannte Schicht kontaktiert werden, so daß die genannten Photoelektronen von jenen Bereichen emittiert werden.

2. Verfahren nach Anspruch 1, bei dem das genannte Substrat (61) aus GaAs, GaP, Quarz oder Saphir hergestellt ist.

3. Verfahren nach Anspruch 1 oder 2, bei dem das genannte Maskenmaterial (62) Pt, Cr, W, Mo, Ta, Au, Ag, oder Ti ist.

4. Verfahren nach einem der vorhergehenden Ansprüche, bei dem die genannte darüberliegende Schicht (63) aus einem Alkalimetall oder einem Erdalkalimetall hergestellt ist.

5. Verfahren nach Anspruch 4, bei dem die genannte darüberliegende Schicht (63) aus Cs hergestellt ist.

6. Verfahren nach Anspruch 4, bei dem die genannte darüberliegende Schicht (63) aus Ba hergestellt ist.

7. Verfahren nach Anspruch 4, 5 oder 6, bei dem die genannte darüberliegende Schicht (63) mittels Ionenstrahleinstrahlung in einem Vakuum gebildet wird.

8. Verfahren nach Anspruch 1, 2 oder 3, bei dem die genannte darüberliegende Schicht (63) aus Cs-behandeltem Sb, Cs-behandeltem Te, oder Cs-behandeltem $Ag_2O$ hergestellt ist.

Fig. 1

Fig. 2

Fig. 3

Fig. 4

EP 0 182 665 B1

# Fig. 5

# Fig. 6

# Fig. 7

61 GaAs

63 Cs
62 Pt
63
63

hν

# Fig. 9

CONDUCTION BAND
Eα

EG

VALENCE BAND

φ

GaAs

Cs

## Fig. 8

## Fig. 10

# Fig. 11

# Fig. 12

# Fig. 13